# EUROPEAN PATENT SPECIFICATION

(11) **EP 3 736 837 B1**
(45) Date of publication and mention of the grant of the patent: **15.10.2025**
(21) Application number: 20172839.1
(22) Date of filing: 05.05.2020
(51) Int. Cl.: H01B 13/012, H01R 43/28, H01B 13/34

(54) **WIRE HARNESS PRODUCING DEVICE**
VORRICHTUNG ZUR HERSTELLUNG VON KABELBÄUMEN
DISPOSITIF DE PRODUCTION D'UN HARNAIS DE CÂBLES

(30) Priority: 10.05.2019 JP 2019089966
(43) Date of publication of application: 11.11.2020
(73) Proprietor: Proterial, Ltd., Tokyo 135-0061 (JP)
(72) Inventor: KAWASE, Kenji, Tokyo, 108-8224 (JP)
(74) Representative: Betten & Resch

(56) References cited:
- EP-A1- 3 065 145
- EP-A1- 3 301 688
- EP-A1- 3 594 971
- US-A1- 2015 241 473
- US-A1- 2016 064 121
- PROJECTIONWORKS: "Wire harness assembly with projected work instructions", 11 May 2017 (2017-05-11), pages 1, XP054982307, Retrieved from the Internet <URL:https://www.youtube.com/watch?v=nlT2w082mrc> [retrieved on 20210110]

## Description

### BACKGROUND OF THE INVENTION

### 1. FIELD OF THE INVENTION

The present invention relates to a wire harness producing device.

### 2. DESCRIPTION OF THE RELATED ART

A wire harness designed to be used in a train vehicle such as a train or the like is configured with a plurality of electric wires being bundled together therein. In producing the wire harness, the wire harness is assembled by cutting each of the plurality of electric wires to a preset electric wire length, laying them out along a full scale wire laying out drawing, and fitting the laid out electric wires or the bundle of the laid out electric wires with a component to be attached at a predetermined position thereon (see e.g. US Patent Application Publication No. 2016/0064121 A1).

US Patent Application Publication No. 2016/0064121 A1 discloses a method of displaying a full scale wire laying out drawing (a full scale wire laying out image) on a display, and laying out electric wires along the wire laying out image.

EP 3 301 688 A1 discloses a wire harness manufacturing system including a display unit, a wire cutting machine that draws an electric wire from a wire feed reel and cuts the electric wire to a predetermined length, a control unit that directs the display unit to display a wire laying image and wire work identification information for identifying a work regarding each electric wire, the wire laying image including a plurality of wire images showing the plurality of electric wires in the laid state and the wire work identification information being displayed in the vicinity of the corresponding wire image, and a memory unit that stores the wire laying image and work instruction information so as to correspond to the wire work identification information, the work instruction information including cut length of the electric wire. The control unit (90) sends the cut length information to the wire cutting machine (6).
EP 3 594 971 A1 and EP 3 065 145 A1 disclose a wire harness electric wire length correcting device, which corrects a design value of an electric wire length of an electric wire included in a wire harness, includes an electric wire identifying means including an identification mark, which is attached to an end portion of the electric wire, and which is to be cut off from the electric wire when the wire harness is installed on an installation target object, so as to use the identification mark to identify which electric wire an end cut off from the electric wire has been cut off from, a measuring means for measuring a length of the cut off end, and a correcting means for, for the electric wire identified by the electric wire identifying means, correcting the design value of the electric wire length of that electric wire, based on the length of the cut off end measured by the measuring means.
US 2015/241473 A1 discloses a system to perform tests quickly and accurately to wiring harnesses. The system comprises a workstation equipped with an electrical test machine with test terminals disposed on the end of extendable hoses, a connection interface between harness connectors and terminals tests, a working board to perform on it the tests to a wiring harness, one or more projection devices arranged to project images onto the working board and a computer system to supply such projection devices with images to assist the operators performing the tests. The connection interface is formed by adapter modules connectable by one side to the wiring harness connectors and by the other to the test terminals. Test terminals and adapter modules comprise electronic circuits and external identification labels holding identification information.
ProjectionWorks: "Wire harness assembly with projected work instructions", 11 May 2017 (2017-05-11), page 1, XP054982307, Retrieved from the Internet: URL:https://www.youtube.com/watch?v=nIT2w082mrc [retrieved on 2021-01-10], is a video, which discloses from minute 4:48 to 5:05 of the video displaying a guide indicator for indicating to an operator a displaying position for the next one of the wire laying out position indicators.

### SUMMARY OF THE INVENTION

The wire harness configured to be used in a train vehicle such as a train or the like is constituted by using a large number of electric wires. For that reason, in order to reduce the occurrence of an incorrect operation such as an incorrect wiring or the like, guiding the operation, supporting the operator, and enhancing the operation efficiency is desired.

Accordingly, it is an object of the present invention to provide a wire harness producing device, that is designed to ensure the improvement of the operation efficiency in wire laying out operation and the like.

The present invention is defined in independent claim 1. The dependent claims define embodiments of the invention.

### Points of the invention

It is possible to provide the wire harness producing device, that is designed to ensure the improvement of the operation efficiency in wire laying out operation and the like.

### BRIEF DESCRIPTION OF THE DRAWINGS

**FIG. 1** is a schematic configuration diagram of a wire harness producing device according to one embodiment.
**FIG. 2**A is an exploded perspective view showing a work bench.

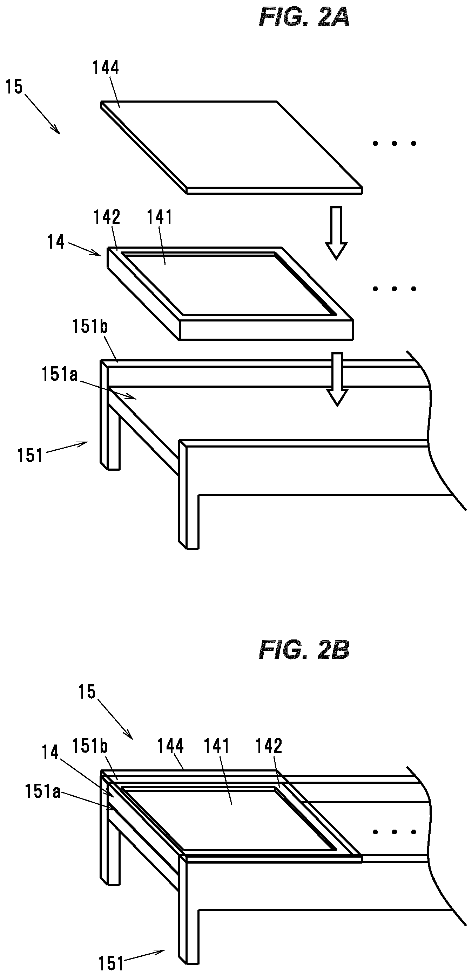

**FIG. 2**B is a perspective view showing the work bench.

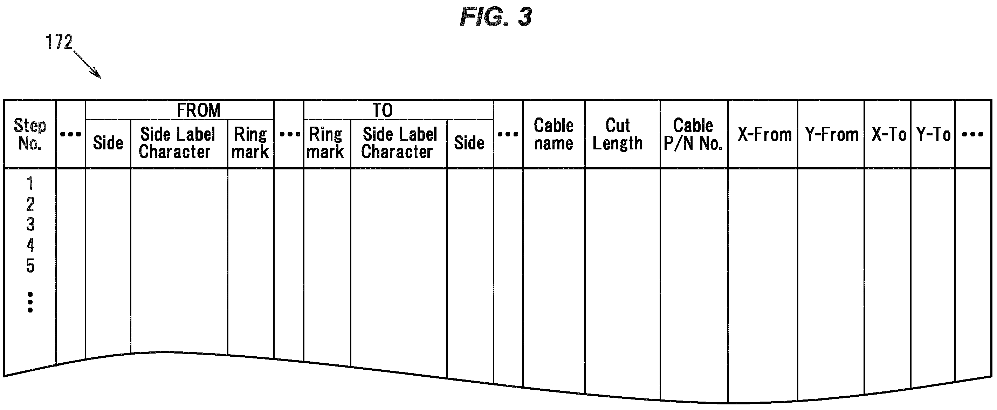

**FIG. 3** is a diagram showing one example of operation recipe information.

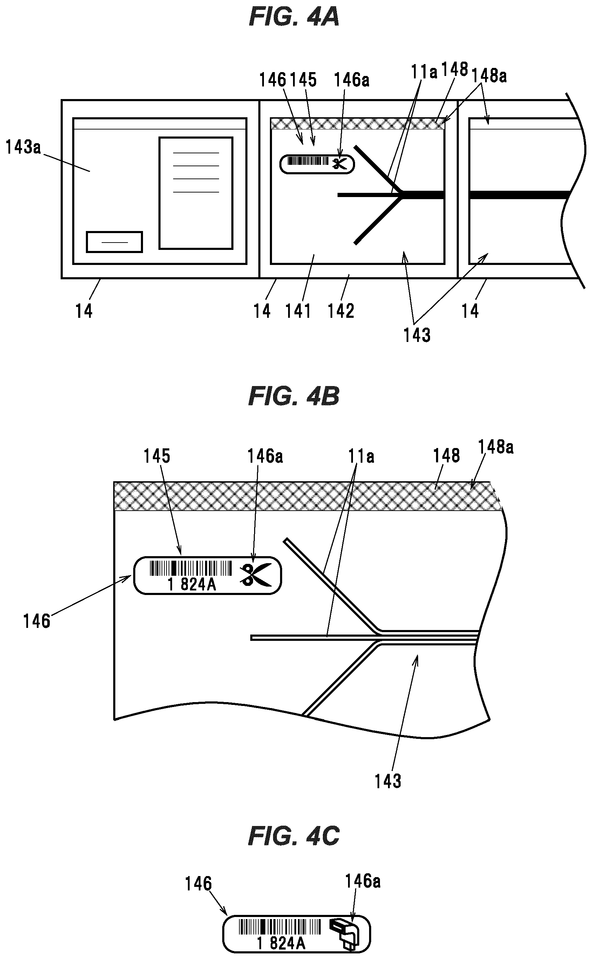

**FIG. 4**A is a diagram showing a display example on display devices.
**FIG. 4**B is an enlarged view of an essential portion of the display example shown in **FIG. 4**A.
**FIG. 4**C is a diagram showing another example of an icon.

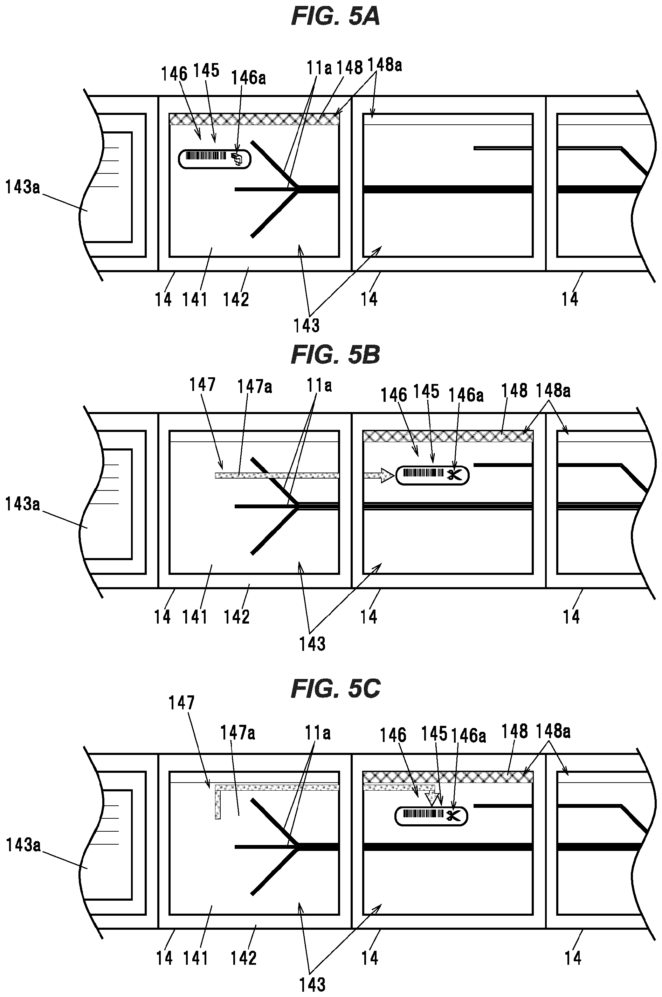

FIGS. **5**A to **5**C are diagrams for explaining a guide indicator.

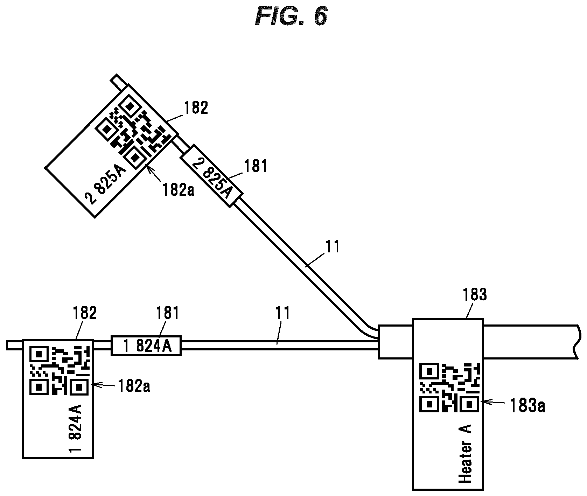

**FIG. 6** is a diagram showing end portions of electric wires each being fitted with a ring mark and a mark tape thereon.

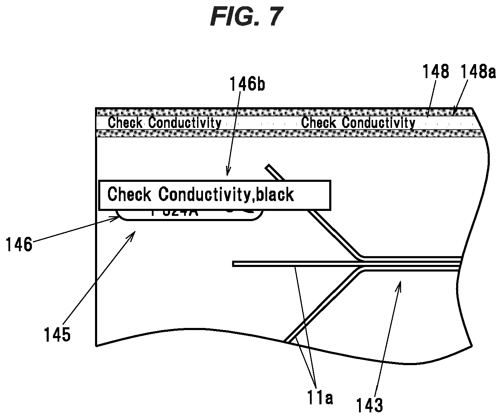

**FIG. 7** is a diagram showing a display example during continuity checking operation.

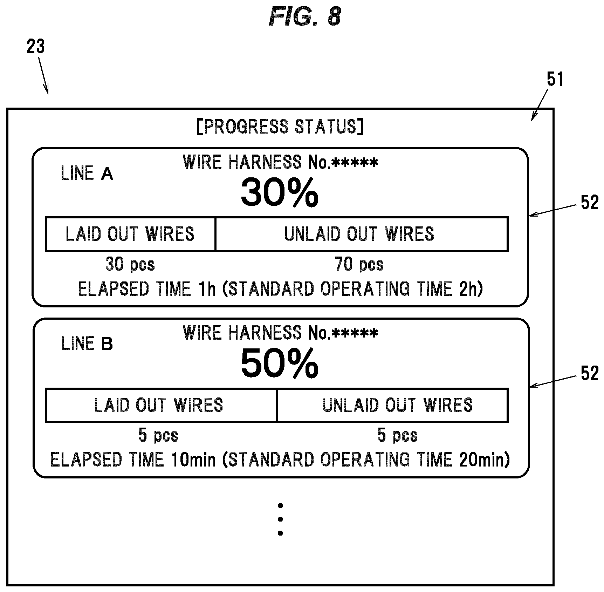

**FIG. 8** is a diagram showing one example of a progress status display screen.

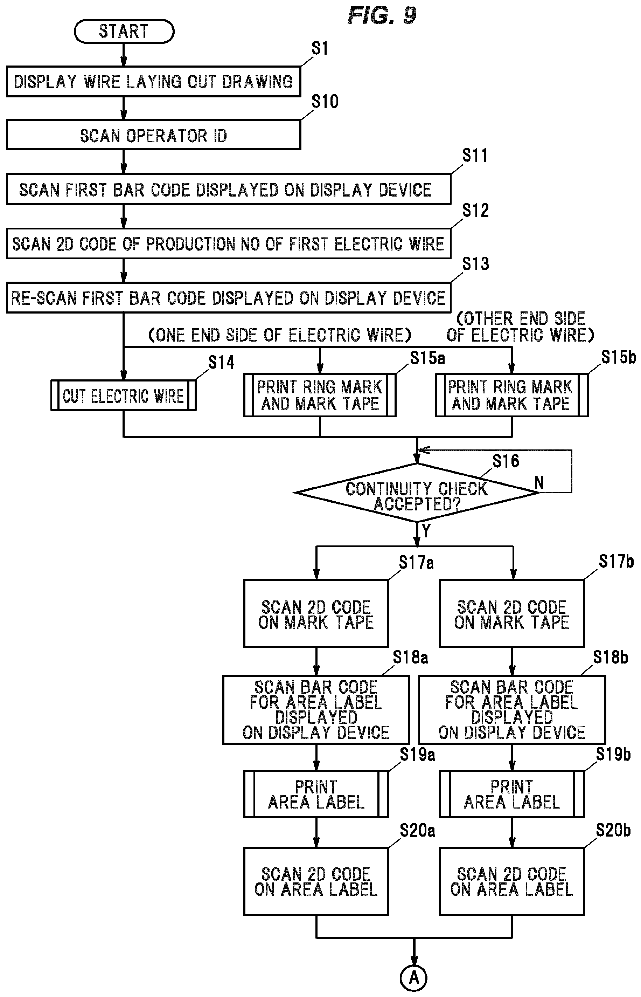

**FIG. 9** is a flow chart showing a procedure for producing a wire harness.

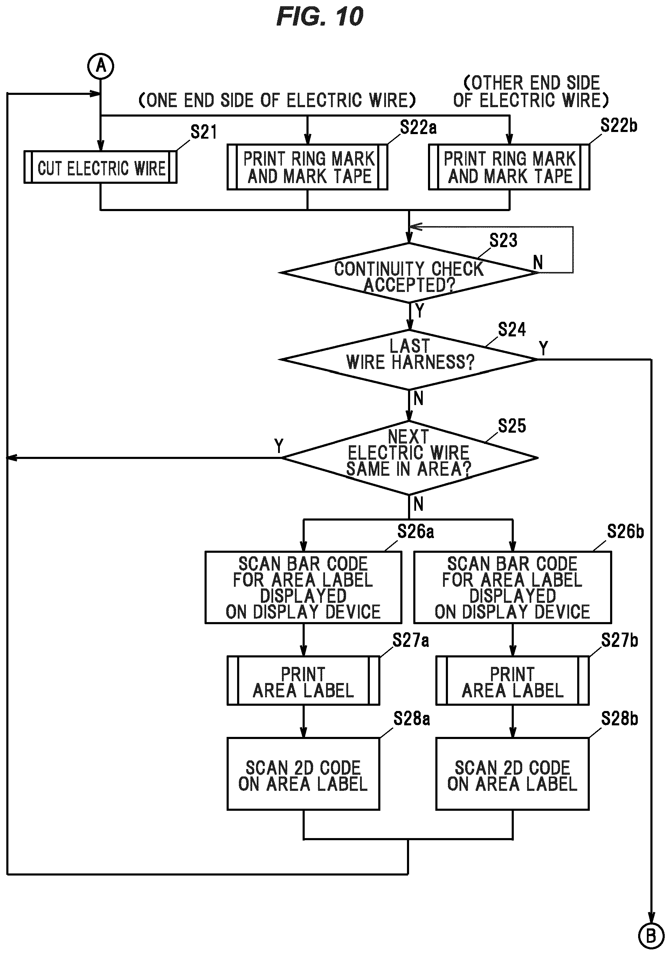

**FIG. 10** is a flow chart showing a procedure for producing the wire harness.

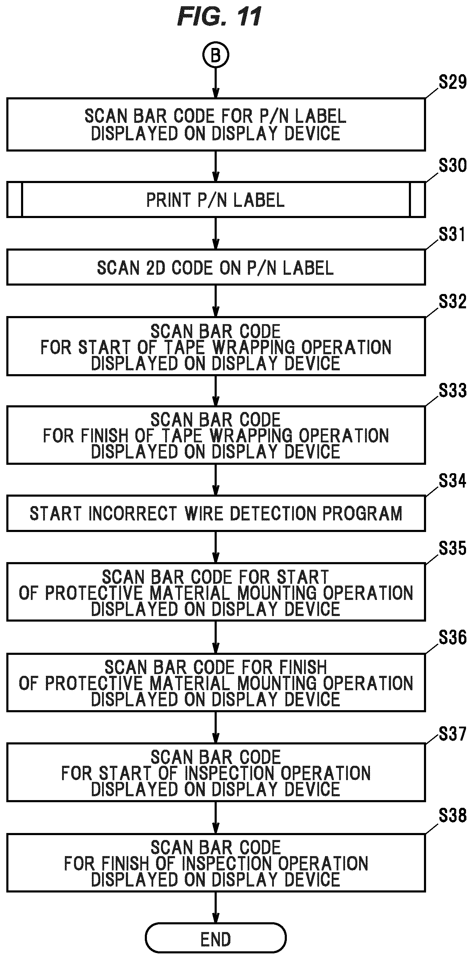

**FIG. 11** is a flow chart showing a procedure for producing the wire harness.

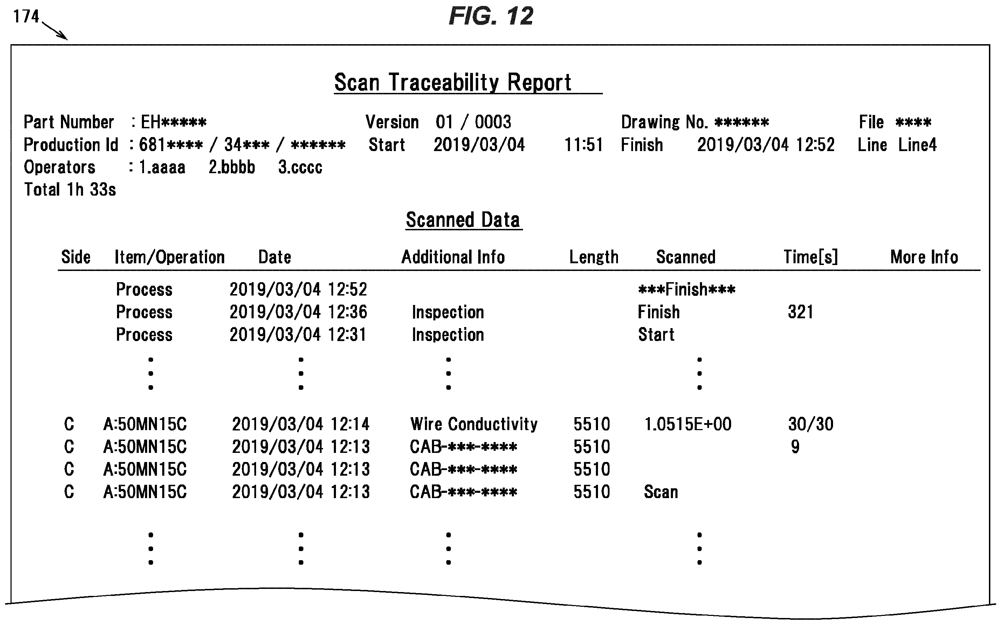

**FIG. 12** is a diagram showing one example of operation history information.

### DETAILED DESCRIPTION OF THE PREFERRED EMBODIMENTS

### [Embodiment]

An embodiment will be described below in conjunction with the accompanying drawing.

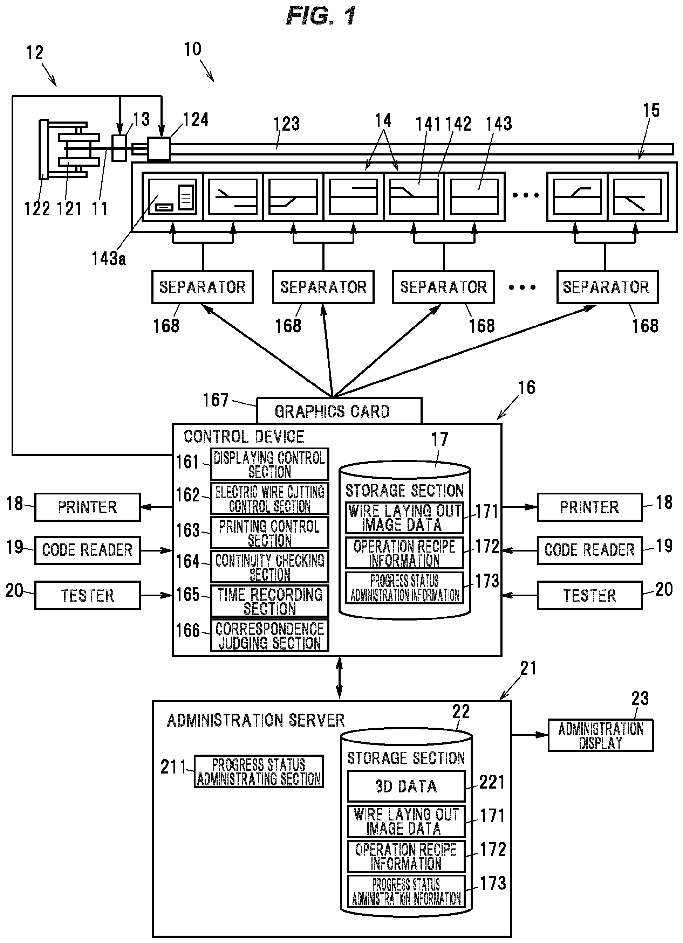

**FIG. 1** is a schematic configuration diagram of a wire harness producing device **10** according to the present embodiment. A wire harness to be produced in the present embodiment is designed to be used in, e.g., wiring between devices in a train.

As shown in **FIG. 1****,** the wire harness producing device **10** is a device designed to produce the wire harness by arranging a plurality of display devices **14** end to end, each configured to include a display portion **141** and a bezel portion **142** arranged around a periphery of the display portion **141,** displaying a wire laying out drawing (a wire laying out image) **143** in a full size on the plurality of display devices **14,** and laying out an electric wire **11** along the wire laying out drawing **143.**

The wire harness producing device **10** is configured to include an electric wire feeding device **12,** an electric wire cutting machine **13,** which is configured to cut the electric wire **11** fed from the electric wire feeding device **12,** a work bench **15,** which is composed of the plurality of display devices **14** arranged end to end, and a control device **16,** which is configured to perform a control on the electric wire feeding device **12** and the electric wire cutting machine **13,** and a displaying control on the plurality of display devices **14,** and the like.

The electric wire **11** is configured as a linear shape conductor coated with an electrical insulating member around its outer periphery, but that electric wire **11** may, as with a LAN cable, integrally be configured in such a manner that a plurality of the linear shape conductors are coated with the electrical insulating members around their outer peripheries respectively, and then covered together with an outer sheath therearound. Here, the electrical insulating members are made of an electrically insulative resin and may be configured as one layer or a plurality of layers. The outer sheath may be formed by solid extrusion in such a manner as to impregnate the spaces between the electrical insulating members, or may be formed in a tubular shape.

The electric wire feeding device **12** is configured to include a reel **121** with the electric wire **11** being wound therearound, a supporting member **122,** which is configured to pivotably support the reel **121,** and a transfer robot **124,** which is configured to hold that electric wire **11** fed from the reel **121,** run on a rail **123,** and transfer (pull out) that electric wire **11.** The reel **121** is fitted with an electric wire identification code (not shown), which is configured to identify a type of the electric wire **11** being wound therearound. The rail **123** is configured to be provided above the work bench **15,** and being fixed to the work bench **15.**

The electric wire cutting machine **13** is configured to use a built-in cutting blade (not shown), to cut that electric wire **11** pulled out by the transfer robot **124.** The type of the electric wire **11** to be laid out can be altered by altering the reel **121** supported by the supporting member **122.** A feeder, though not shown, is provided in the subsequent stage of the reel **121,** and the length of the electric wire **11** pulled out by that feeder is measured. Note that the electric wire feeding device **12** may not be provided with the transfer robot **124,** and that the electric wire **11** fed out from the feeder may be pulled out by human hand. Further, no feeder may be provided, and the electric wire **11** may be pulled out from the reel **121** by human hand.

The work bench **15** is configured as a bench designed for a wire laying out operation for the electric wire **11** to be performed thereon, and being provided with the plurality of display devices **14** on its top surface, for displaying a full scale wire laying out image. Since the wire harness for a train vehicle is very long, e.g., **30** m, the work bench **15** is constituted by arranging the plurality of display devices **14** end to end in one row. Herein, the work bench **15** is constituted by arranging **24** of the display devices **14** end to end in one row. Note that the number of the display devices **14** to be arranged end to end on the work bench **15** is not limited to the above number. Also, the arrangement of the plurality of display devices **14** is not limited to the illustrated one, but can appropriately be altered according to the shape of the wire harness to be produced. For example, the plurality of display devices **14** may be arranged in rows and columns in a matrix.

The plurality of display devices **14** are made of, e.g., a liquid crystal display or the like. As shown in **FIGS. 2**A and **2**B, the work bench **15** has a frame **151** having a recessed receiving portion **151**a for the plurality of display devices **14** to be set therein, and is constituted by the plurality of display devices **14** being received in the receiving portion **151**a from above the frame **151.** Plate-shape transparent protecting covers **144** are provided on the plurality of display devices **14,** respectively, to protect the respective display portions **141** of the plurality of display devices **14.** The transparent protecting covers **144** are made of a transparent member such as an acrylic or the like. A wire harness production is performed by laying out the electric wire **11** cut by the electric wire cutting machine **13** on the transparent protecting covers **144** in such a manner as to allow the electric wire **11** to follow the wire laying out drawing **143** displayed on the plurality of display devices **14,** and subsequently appropriately performing tape wrapping, protective material mounting, and the like.

The transparent protecting covers **144** are provided on the plurality of display devices **14,** respectively, in such a manner as to cover uneven surfaces between the respective display portions **141** and the respective bezel portions **142** of the plurality of display devices **14.** The transparent protecting covers **144** serve to protect the respective display portions **141** of the plurality of display devices **14** from being damaged, and to substantially prevent the electric wire **11** to be laid out from being damaged due to interfering with the uneven surfaces between the respective display portions **141** and the respective bezel portions **142** of the plurality of display devices **14.**

The plurality of display devices **14** may be provided with one transparent protecting cover **144,** but in this case, in the event of damage to the one transparent protecting cover **144,** replacing the one transparent protecting cover **144** is wasteful, or in the event of a fault in the display devices **14,** replacing the display devices **14** is time consuming. In light of the foregoing, in the present embodiment, the transparent protecting covers **144** are each individually being provided for each of the plurality of display devices **14.** The transparent protecting covers **144** can be detached upward from the display devices **14.** By detaching the transparent protecting covers **144** from the display devices **14,** the display devices **14** can also be detached upward from the frame **151** of the work bench **15.** Thus, even when the work space is narrow, the transparent protecting covers **144** or the display devices **14** can easily be replaced. Note that even when the plurality of display devices **14** are arranged in a matrix, the transparent protecting covers **144** can be applied thereto.

The lengths of the transparent protecting covers **144** in a direction of the arrangement of the plurality of display devices **14** arranged end to end in one row are configured to be substantially equal to those of the plurality of display devices **14.** Further, the widths of the transparent protecting covers **144** in a width direction perpendicular to the direction of the arrangement of the plurality of display devices **14** arranged end to end in one row are configured to be slightly larger than those of the plurality of display devices **14.** The transparent protecting covers **144** are fixed to the frame **151** of the work bench **15** by fixing respective two projecting end portions of the transparent protecting covers **144** being projected from the plurality of display devices **14** in the width direction of the plurality of display devices **14** to two edge portions **151**b of the frame **151** with screws or the like. Note that the transparent protecting covers **144** for the plurality of display devices **14** may or may not be contiguous to the respective bezel portions **142** of the plurality of display devices **14.**

It is desirable that joined portions between adjacent ones of the transparent protecting covers **144** for the plurality of display devices **14** be located on the respective bezel portions **142** of the plurality of display devices **14.** This is because if the joined portions between the adjacent ones of the transparent protecting covers **144** lie on the respective display portions **141** of the plurality of display devices **14,** it may be difficult to read in a code with a code reader **19,** which will be described later. In addition, a transparent protective tape may be provided on the joined portions between the adjacent ones of the transparent protecting covers **144.** The protective tape is configured to play a role in substantially preventing the electric wire **11** to be laid out from being damaged due to interference with the end portions of the transparent protecting covers **144,** in the event of an uneven surface formation at the joined portions between the adjacent ones of the transparent protecting covers **144** due to a manufacturing tolerance or the like, or in the event of the end portions of the transparent protecting covers **144** being separated from each other for some reason.

In order to suppress the eyestrain of an operator, the transparent protecting covers **144** for the plurality of display devices **14** may each be configured in such a manner as to include a blue light blocking layer that attenuates or blocks blue light having a wavelength of **380** nm to **500** nm. Further, the transparent protecting covers **144** may each be configured in such a manner as to include on their surfaces a reflection suppressing layer for suppressing the occurrence of reflected glare of external lighting or the like.

The control device **16** is configured to include a storing section **17** that is configured to store wire laying out image data **171,** operation recipe information **172,** and the like. The wire laying out image data **171** is designed as image data for the wire laying out drawing **143** to be displayed on the plurality of display devices **14.** The operation recipe information **172** is designed as a database with wire laying out order numbers of the electric wires **11** being time series ordered therein. In other words, the operation recipe information **172** is a database of each kind of information on all of the electric wires **11** to be laid out having been sorted in an order in which those electric wires **11** are to be laid out. Note that the present invention is not limited to the foregoing, but that the wire laying out order numbers may be stored in that database for each of the electric wires **11,** and that it is not essential that each kind of information on all of the electric wires **11** to be laid out is sorted in the wire laying out order of the electric wires **11** within the database.

As shown in **FIG. 3****,** in the operation recipe information **172,** for each one of the electric wires **11** to be laid out, for example, a name (Cable name) of each one of the electric wires **11,** an electric wire length design value (Cut Length) of each one of the electric wires **11,** and a production number (Cable P/N No.) for denoting a type of each one of the electric wires **11** are configured. Further, in the operation recipe information **172,** for example, for each of respective two end portions (From and To) of each one of the electric wires **11** to be laid out, a ring mark number (Ring mark) of each one of the electric wires **11** which will be described later, a side (Side) for indicating a position of one or the other of the respective two end portions of each one of the electric wires **11** and denoting a connection destination area (e.g., a connection destination device or the like) of each one of the electric wires **11,** and the like are configured.

Further, in the present embodiment, the operation recipe information **172** is configured to include coordinate information for indicating two displaying positions for a wire laying out position indicator (an identification code), which will be described later, for each one of the electric wires **11** to be laid out. The operation recipe information **172** is configured to include two pieces of the coordinate information of the vicinities of the respective two end portions of each one of the electric wires **11** to be laid out. An X-From and a Y-From in **FIG. 3** denote an X coordinate and a Y coordinate respectively showing the respective wire laying out position indicator (identification code) displaying position adjacent to one of the respective two end portions of each one of the electric wires **11** to be laid out. An X-To and a Y-To in **FIG. 3** denote an X coordinate and a Y coordinate respectively showing the respective wire laying out position indicator (identification code) displaying position adjacent to the other one of the respective two end portions of each one of the electric wires **11** to be laid out. Note that the specific contents of the operation recipe information **172** are not limited to the foregoing, but can appropriately be configured.

The control device **16** is configured to include a displaying control section **161,** which is configured to perform a displaying control on the plurality of display devices **14** of the work bench **15,** an electric wire cutting control section **162,** which is configured to perform a cutting control on those electric wires **11,** a printing control section **163,** which is configured to print, with two printers **18,** identification marks to be attached to the respective two end portions respectively of each one of those electric wires **11,** and a continuity checking section **164** that is configured to perform a continuity checking processing on each one of those electric wires **11.** The control device **16** is configured in such a manner that the plurality of display devices **14** of the work bench **15,** two code readers **19,** the transfer robot **124,** the electric wire cutting machine **13,** the two printers **18,** and two continuity checking testers **20** are connected to the control device **16.**

The displaying control section **161** of the control device **16** is configured to display the full scale wire laying out drawing **143** on each of the plurality of display devices **14** of the work bench **15,** on the basis of the wire laying out image data **171** stored in the storing section **17** of the control device **16.** The wire laying out image data **171** output from the displaying control section **161** is separated by means of graphics cards **167** into every two of the display devices **14,** and the separated image data **171** are further separated into two each by means of separators **168** and displayed on the respective display portion **141** of each of the plurality of display devices **14.**

In addition, in the present embodiment, the displaying control section **161** of the control device **16** is configured to look up the operation recipe information **172,** and in turn display the wire laying out position indicators on the plurality of display devices **14** of the work bench **15** in accordance with the wire laying out order of the electric wires **11.** In addition, the displaying control section **161** of the control device **16** is configured to erase the display of the wire laying out position indicators associated with the electric wires **11** having been laid out. That is, the displaying control section **161** of the control device **16** is configured to display only the wire laying out position indicator for the electric wire **11** currently being laid out. The wire laying out position indicators refer to the indicators configured to indicate to the operator the positions of the electric wires **11** to be laid out.

As shown in **FIGS. 4**A and **4**B, in the present embodiment, the wire laying out position indicators **145** are each being configured to include a bar code **146** as the respective identification code of each of the electric wires **11** to be laid out. The displaying control section **161** of the control device **16** is configured to create the respective bar code (respective pop-up bar code) **146** configured to be able to identify each of those electric wires **11** to be laid out, and display that created respective bar code **146** on the plurality of display devices **14** of the work bench **15.** The respective bar code **146** is configured to be created from character information in the operation recipe information **172,** for example, number information in a ring mark. Also, the respective bar code **146** may be configured in such a manner as to be created from other information included in the operation recipe information **172,** and may be configured in such a manner as to include a plurality of pieces of information. The displaying control section **161** of the control device **16** is configured to look up the operation recipe information **172,** and display the respective wire laying out position indicator **145** including the respective bar code **146** thereon of each of those electric wires **11** to be laid out, in the two displaying positions indicated by the coordinate information in the operation recipe information **172,** in such a manner as to allow the wire laying out position indicator **145** to be superimposed on the wire laying out drawing **143.**

The wire laying out drawing **143** is configured to include electric wire images **11**a of a plurality of the laid out electric wires **11.** Since those electric wires **11** have their two end portions, in the present embodiment, the operation recipe information **172** is configured to include the two pieces of the coordinate information therein in correspondence with the respective two end portions, respectively, of each of those electric wires **11.** The displaying control section **161** of the control device **16** is configured to display the two wire laying out position indicators **145** for each one of those electric wires **11,** in the two displaying positions indicated by the two pieces of the coordinate information in the operation recipe information **172,** that is, in the two displaying positions adjacent to the respective two end portions, respectively, of that one of those electric wires **11** on the wire laying out drawing **143.**

Note that the displaying control section **161** of the control device **16** may be configured in such a manner as to prestore in the operation recipe information **172** the image information in the respective two bar codes **146** of each of those electric wires **11** to be laid out, and act to retrieve that image information in the respective two bar codes **146** and display the respective two wire laying out position indicators **145** including the respective two bar codes **146** thereon on the designated coordinates. Further, the identification codes to be included in the respective two wire laying out position indicators **145** of each of those electric wires **11** to be laid out are not limited to the bar codes **146,** but may be, e.g., a two-dimensional code (a QR code (registered trademark)).

Note that it is not essential that the wire laying out position indicators **145** include the identification codes (the bar codes **146),** but that the wire laying out position indicators **145** may be composed of a mark such as an arrow or the like, an icon, a character, and the like. Although details will be described later, in the present embodiment, reading in the identification codes (the bar codes **146)** is used as a trigger for operation start or operation finish, but when no identification code is included in the wire laying out position indicators **145,** the plurality of display devices **14** can be configured with a touch panel, for example, so that the operation start or the operation finish can be triggered by the operator touching the wire laying out position indicators **145.** Further, an input device such as a switch, or a mouse, or a keyboard or the like connected to the control device **16** may be used so that the trigger for the operation start or the operation finish can be input to the control device **16** by that input device.

The wire laying out drawing **143** is displayed on the plurality of display devices **14** of the work bench **15** in such a manner that the lengths of those electric wires **11** (the lengths of the electric wire images **11**a) on the wire laying out drawing **143** are the full scale lengths of those electric wires **11.** Note that the thicknesses of the electric wire images **11**a may be thicker or thinner than the full scale thicknesses of the electric wires **11.** By displaying the electric wire images **11**a thicker than the full scale thicknesses of the electric wires **11,** when the electric wires **11** are laid out, the electric wire images **11**a thereof are substantially prevented from being hidden by those electric wires **11,** and so the wire laying out operation is facilitated.

Furthermore, in the present embodiment, the wire laying out position indicators **145** are each being configured to include thereon a icon **146**a indicating an operation content. The displaying control section **161** of the control device **16** is configured to display the bar codes **146** as the identification codes and the icons **146**a as the wire laying out position indicators **145** indicating the operation content adjacent to those bar codes **146.** For example, the icon **146**a which depicts scissors as shown in **FIGS. 4**A and **4**B denotes an electric wire **11** feeding and cutting operation, and indicates that when the bar code **146** has been read in by the code reader **19,** the electric wire **11** feeding and cutting is performed. Further, the icon **146**a which depicts the code reader **19** as shown in **FIG. 4**C serves as an indicator requiring the wire laying out to be followed by reading in the bar code **146** with the code reader **19.** By displaying the icon **146**a indicating the operation content along with the bar code **146,** it is possible for the operator to intuitively decide on the operation to be performed, which results in a contribution to an enhancement in operation efficiency.

Furthermore, in the present embodiment, the displaying control section **161** of the control device **16** is configured in such a manner that when switching the display of the wire laying out position indicators **145,** that displaying control section **161** erases the current wire laying out position indicators **145** while displaying the next wire laying out position indicators **145,** and displaying guide indicators for indicating to the operator the displaying positions for the next wire laying out position indicators **145.** For example, when the wire laying out operation for the electric wires **11** has been completed in the state of **FIG. 5**A and when the bar code **146** has been read in with the code reader **19,** as shown in **FIG. 5**B, the current wire laying out position indicator **145** is erased and the wire laying out position indicator **145** is displayed adjacent to the end portion of the electric wire **11** to be next laid out. At this point of time, according to the invention, an arrow **147**a, which is extending from the displaying position for the erased wire laying out position indicator **145** to the displaying position for the next wire laying out position indicator **145,** is displayed as the guide indicator **147.**

Although in the example of **FIG. 5**B, the linear shape arrow **147**a is displayed from the displaying position for the erased wire laying out position indicator **145** to the displaying position for the next wire laying out position indicator **145,** the present invention is not limited to the foregoing, but for example, as shown in **FIG. 5C****,** the arrow **147**a may be displayed in such a manner as to bypass the electric wire images **11**a on the wire laying out drawing **143.** Although in **FIG. 5C**, as one example, a case is shown in which the arrow **147**a is displayed in such a manner as to be passed through the illustrated upper edge portion of the display devices **14,** the shape, the path, and the like of the arrow **147**a can be appropriately altered. The arrow **147**a may be displayed with a color different from a background color of the wire laying out drawing **143** so that the operator can easily distinguish the color of the arrow **147**a therefrom.

By displaying the guide indicator 147 even when the next wire laying out position indicator **145** is displayed on the display device **14** away from the display device **14** with the operation currently being in progress thereon, the operator can intuitively recognize the position of the next wire laying out position indicator **145,** which results in a contribution to an enhancement in operation efficiency. Note that the guide indicator **147** may be displayed only when the display device **14** with the wire laying out position indicator **145** to be erased being displayed thereon and the display device **14** with the next wire laying out position indicator **145** to be displayed thereon are different from each other.

Further, the displaying control section **161** of the control device **16** is configured in such a manner as to display an operation in progress indicator **148** on a predetermined region of the display device **14** with the wire laying out position indicator **145** being displayed thereon, with the operation in progress indicator **148** indicating that the wire laying out position indicator **145** is displayed on that display device **14.** In the present embodiment, as shown in **FIGS. 4**A to **4**C and **5**A to **5**C, the displaying control section **161** of the control device **16** is configured in such a manner as to display the operation in progress indicator **148** on operation in progress indicator regions **148**a, which are set on the respective illustrated upper edge portions of the plurality of display devices **14.** The operation in progress indicator **148** is displayed on the operation in progress indicator regions **148**a, for example, with the operation in progress indicator regions **148**a set to have a color different from that of the wire laying out drawing **143** (or with that different color set to blink).

By displaying the operation in progress indicator **148** on the display devices **14,** the operator can easily recognize the display device **14** with the operation to be performed thereon, and thereby ensure the improvement of the operation efficiency. Further, by displaying the operation in progress indicator **148** on the display devices **14,** for example, when the image of the work bench **15** is recorded by a monitoring camera in the factory, it is possible to easily identify the display device **14** with the operation currently being performed thereon, and it is therefore easy for the administrator to grasp the operation status.

In the present embodiment, the color of the operation in progress indicator **148** during the continuity checking operation, which will be described later, is made different from the color of the operation in progress indicator **148** during the other operations such as the wire laying out operation and the like. Further, character information indicating the continuity check (character information such as Check Conductivity or the like) is inserted into the operation in progress indicator **148** during the continuity checking operation (see **FIG.** 7). This is because the continuity checking operation is required to be performed at both the end portions of the electric wire **11** at the same time, and therefore each of the operators performing the operation at both the end portions of the electric wire **11** is required to recognize performing the continuity checking operation and promptly perform the operation.

In order to allow the operators to easily discriminate the electric wire images 11a of the electric wires **11** to be laid out, the displaying control section **161** of the control device **16** may be configured in such a manner as to display only the end portions of the electric wire images **11**a to be laid out, or the entire electric wire images **11**a to be laid out, with a color different from the colors of the other electric wire images **11**a. Further, in order to allow the operators to easily recognize the branching positions of the electric wires **11,** the displaying control section **161** of the control device **16** may be configured in such a manner as to display the colors of the branching portions of the electric wire images **11**a to be laid out, with a color different from the colors of the other electric wire images **11**a. Further, the displaying control section **161** of the control device **16** may be configured in such a manner as to display the color of each of the electric wires images **11**a on the wire laying out drawing **143** with different colors before the wire laying out, during the wire laying out operation, and after the wire laying out.

The electric wire cutting control section **162** of the control device **16** is configured to control the electric wire feeding device **12** and the electric wire cutting machine **13,** to perform a cutting control to cut each of those electric wires **11** to a designated length. The electric wire cutting control section **162** of the control device **16** is configured to retrieve the design value of the electric wire length of one of those electric wires **11** from the operation recipe information **172,** and act to pull out the one of those electric wires **11** by a predetermined length with the transfer robot **125,** and when the length of that pulled out electric wire **11** measured by the feeder becomes equal to the design value of the electric wire length in the operation recipe information **172,** cut that pulled out electric wire **11** with the electric wire cutting machine **13.** This results in those electric wires **11** having the lengths designated according to the design values of the electric wire lengths in the operation recipe information **172.**

The printing control section **163** of the control device **16** is configured to print, with the two printers **18,** the identification marks to be attached to the respective two end portions, respectively, of each of those electric wires **11.** In the present embodiment, the two printers **18** are arranged on both the end portions, respectively, of the work bench **15,** so as to attach the identification marks to the respective two end portions, respectively, of each of those electric wires **11.** Further, in the present embodiment, the two printers **18** are used to print ring marks as the identification marks, respectively, and mark tapes with two-dimensional codes (QR codes (registered trademark)), respectively, thereon configured to be able to identify each of those electric wires **11.** Note that the two code readers **19** and the two continuity checking testers **20** are also being provided so as to be able to perform the operation at the respective two ends, respectively, of each of those electric wires **11.**

As shown in **FIG. 6****,** the ring marks **181** and the mark tapes **182** printed by the two printers **18** are configured to be attached to the respective two end portions, respectively, of each of those electric wires **11.** In the present embodiment, the mark tapes **182** are configured in such a manner that the two-dimensional codes **182**a are printed on the mark tapes **182** respectively, but may be configured in such a manner that the bar codes are printed on the mark tapes **182** respectively. In addition, a vicinity of a branching portion of the electric wires **11** is fitted with an area label tape **183** which is configured to indicate an area (an area label in the operation recipe information **172)** of a connection destination of the electric wires **11** extended out from that branching portion. As with the mark tapes **182,** the area label tape **183** is configured in such a manner that a two-dimensional code **183**a configured to be able to specify the area of the area label connection destination is printed on the area label tape **183.** The mark tapes **182** and the area label tapes **183** are adhesive seals with the two-dimensional codes **182**a and **183**aly being printed thereon, and the mark tapes **182** and the area label tapes **183** are attached to each of the electric wires **11** in such a manner that their respective one parts are wrapped around each of the electric wires **11.** The two-dimensional codes **182**a on the mark tapes **182** are configured to be created from character information in the operation recipe information **172.** Also, the two-dimensional codes **182**a may be configured in such a manner as to include a plurality of pieces of information.

The ring marks **181** are a ring-shaped member, and are fitted on each of the end portions of the electric wires **11** by inserting each of the end portions of the electric wires **11** into an inner periphery of each of the ring marks **181** respectively. In the present embodiment, the inner diameters of the ring marks **181** are formed larger than the outer diameters of the electric wires **11,** so that the ring marks **181** are movably fitted on each of the end portions of the electric wires **11** in longitudinal directions of each of the electric wires **11** respectively. Since the mark tapes **182** are located closer to the end portions of the electric wires **11** than the ring marks **181,** the ring marks **181** movable in the longitudinal directions of the electric wires **11** are substantially prevented from slipping off the end portions of the electric wires **11** respectively.

Note that, in the present embodiment, the ring marks **181** and the mark tapes **182** are used as the identification marks, but that the ring marks **181** may be omitted while only the mark tapes **182** may be used as the identification marks. Further, it is naturally possible to use an IC tag, an RFID tag, or the like as the identification marks. Further, the information to be printed on the mark tapes **182,** the ring marks **181,** and the area label tapes **183** may be printed on an outer periphery of each of the electric wires **11** (on an outer periphery of the outer sheath of each of the electric wires **11).**

The continuity checking section **164** of the control device **16** is configured to check the continuity of each of the electric wires **11** after laying out of each of the electric wires **11.** The continuity checking section **164** of the control device **16** is configured to perform the continuity checking by bringing the probes of the two continuity checking testers **20** into contact with the conductor of each of the electric wires **11** at both the end portions of each of the electric wires **11** to obtain the conductor resistance of each of the electric wires **11,** and make a decision as to whether the conductor resistance of each of the electric wires **11** is within a predetermined normal range. In the present embodiment, the continuity checking section **164** of the control device **16** is configured in such a manner as to display an indication of the continuity checking on the plurality of display devices **14** of the work bench **15** by means of the displaying control section **161** of the control device **16** after the laying out of each of the electric wires **11,** and to erase the display of the indication of the continuity checking after continuity checking of each of the electric wires **11.**

As shown in **FIG. 7****,** the continuity check indicator **146**b is displayed in such a manner as to be partially superimposed on the bar codes **146** of the wire laying out position indicator **145,** with the location of the wire laying out position indicator **145** being able to be identified by the operator, but with the bar codes **146** being unable to be read by the operator. This makes it possible to substantially prevent the operator from reading the bar codes **146** and progressing to the next step before the continuity checking. Further, since a part of the wire laying out position indicator **145** can be visually recognized by the operator, it is possible to smoothly perform the reading of the bar codes **146** after the continuity checking. In the present embodiment, a display such as a "Check Conductivity, black" is performed as the continuity check indicator **146**b, so that it is possible to suppress the occurrence of an incorrect continuity checking by presenting the color of the electric wire **11** (the color of the outer sheath of the electric wire **11,** herein, black) to be subjected to the continuity checking.

As shown in **FIGS. 1** and **4**A**,** the display device **14** being arranged closest to the reference end portion is configured to display a production information screen **143**a with production information including the information on the wire harnesses to be produced, the information on the operator, the production procedure, and the like, to be displayed on that production information screen **143**a, but with no images of the wire harnesses to be displayed on that production information screen **143**a. The production information screen **143**a may be configured as a part of the wire laying out image data **171** or may be configured in such a manner as to be created separately from the wire laying out image data **171.**

Further, the control device **16** is configured to include a time recording section **165,** which is configured to store a time at which the two bar codes **146** displayed on the plurality of display devices **14** have been read in by the two code readers **19,** in the storing section **17** of the control device **16** as progress status administration information **173.** The progress status administration information **173** is transmitted to an administrating server **21,** which will be described later, and is used in the administration of the progress information.

Further, the control device **16** is configured to include a correspondence judging section **166** that is configured to make a decision as to whether the code information in the identification marks (the two-dimensional codes **182**a on the mark tapes **182)** read in by the two code readers **19,** and the code information in the identification codes (the bar codes **146)** displayed on the plurality of display devices **14** are in correspondence with each other. In the present embodiment, the code information in the two-dimensional codes **182**a on the mark tapes **182** and the code information in the bar codes **146** displayed on the plurality of display devices **14** are configured to match each other, and the correspondence judging section **166** of the control device **16** is configured to make a decision as to whether the code information in the two-dimensional codes **182**a on the mark tapes **182** read in by the two code readers **19,** and the code information in the bar codes **146** displayed on the plurality of display devices **14** are matching each other.

The correspondence judging section **166** of the control device **16** is configured in such a manner that, as a result of the decision made by the correspondence judging section **166,** if the code information in the two-dimensional codes **182**a on the mark tapes **182** read in by the two code readers **19,** and the code information in the bar codes **146** displayed on the plurality of display devices **14** are not matching each other, then the correspondence judging section **166** displays alert information on the plurality of display devices **14** by means of the displaying control section **161** of the control device **16.** Note that the correspondence judging section **166** of the control device **16** may be configured in such a manner that, for example when the code information in the two-dimensional codes **182**a on the mark tapes **182** read in by the two code readers **19,** and the code information in the bar codes **146** displayed on the plurality of display devices **14** are not matching each other, the correspondence judging section **166** activates an alarm device configured to generate an alarm with sound or light or the like, and provided adjacent to the work bench b**15.**

The time recording section **165** of the control device **16** is equipped with a built-in clock function, and is configured to, each time one of the plurality of electric wires **11** is laid out, store a time at which the one of the plurality of electric wires **11** has been laid out, in the storing section **17** of the control device **16.** In the present embodiment, the time recording section **165** of the control device **16** is configured to store a time at which the identification codes (the bar codes **146)** have been read in by the two code readers **19,** in the storing section **17** of the control device **16.** The time recording section **165** of the control device **16** is configured in such a manner that, as a result of the decision made by the correspondence judging section **166** of the control device **16,** when the correspondence judging section **166** has determined that the code information in the two-dimensional codes **182a** on the mark tapes **182** read in by the two code readers **19,** and the code information in the bar codes **146** displayed on the plurality of display devices **14** are matching each other, the time recording section **165** stores a time at which the bar codes **146** have been read in, in the storing section **17** of the control device **16** as the progress status administration information **173.**

Note that the time at which the identification codes have been read in is not limited to the foregoing, but that the time at which the correspondence judging section **166** of the control device **16** has determined that the code information in the two-dimensional codes **182**a on the mark tapes **182** read in by the two code readers **19,** and the code information in the bar codes **146** displayed on the plurality of display devices **14** are matching each other may be stored as the time at which the identification codes have been read in. That is, the "time at which the identification codes have been read in" may not be strictly the time at which the identification codes have been read in, but the time at which the predetermined decision processing or the like resulting from the identification codes having been read in (in the present embodiment, the processing which determines that the code information in the two-dimensional codes **182**a on the mark tapes **182** read in by the two code readers **19,** and the code information in the bar codes **146** displayed on the plurality of display devices **14** are matching each other) has ended, may be stored as the "time at which the identification codes have been read in".

Further, the time recording section **165** of the control device **16** may be configured in such a manner that, when as described above, the plurality of display devices **14** are configured with the touch panel and the touch operation for the wire laying out position indicators **145** is set as the trigger for the operation start or the operation finish, the time recording section **165** stores the time at which the wire laying out position indicators **145** have been touched, in the storage section **17** of the control device **16.**

Further, the wire harness producing device **10** is configured to include an administrating server **21,** which is provided in such a manner as to be able to communicate with the control device **16.** Only one control device **16** is shown in **FIG. 1****,** but in practice, on each of production lines (the respective work bench **15** of each of the production lines), the respective control device **16** thereof is provided, and the administrating server **21** is provided in such a manner as to be able to communicate with the respective control device **16** of each of the production lines.

The administrating server **21** is configured to perform the creation of the wire laying out image data and the administration of the progress information, and is configured as an appropriate combination of a computing element, a memory, an interface, a hard disk, a software and the like. The storage section **22** of the administrating server **21** is configured to store the wire laying out image data **171** and the operation recipe information **172** of all types of the wire harnesses to be produced within a factory. The administrating server **21** is configured to transmit to the respective control device **16** of each one of the production lines the wire laying out image data **171** and the operation recipe information **172** of the wire harnesses allocated to that one of the production lines.

The administrating server **21** is configured to include a progress status administrating section **211.** The progress status administrating section **211** of the administrating server **21** is configured to act to retrieve the time at which the identification codes have been read in, in other words, the progress status administration information **173,** having been stored in the storage section **17** of the control device **16,** and store that retrieved progress status administration information **173** in the storage section **22** of the administrating server **21,** while acting to obtain a progress status of the production of the wire harness on the basis of that retrieved progress status administration information **173,** and display that obtained progress status on an administrating display **23.** In the present embodiment, a monitor attached to the administrating server **21** is used as the administrating display **23,** but a monitor provided separately from the administrating server **21,** such as a large-screen monitor provided in the factory or the like, may be used as the administrating display **23.**

More specifically, the progress status administrating section **211** of the administrating server **21** is configured to, on the basis of the progress status administration information **173,** obtain the number of the laid out electric wires **11,** the number of the unlaid out electric wires **11,** the proportion of the number of the laid out electric wires **11** to the total number of the electric wires **11** to be laid out, a preset standard operating time (target operating time), an elapsed time from the start of the operation, and the like on each of the production lines, and display them on the administrating display **23** as a progress status display screen.

**FIG. 8** shows one example of the progress status display screen **51.** As shown in **FIG. 8****,** the progress status display screen **51** is configured in such a manner as to display the respective progress status of each of the production lines of the factory, for example. Herein, as one example, a case is shown in which respective individual progress status displaying sections **52** of the two production lines A and B are displayed, but the number of the production lines to be displayed is not limited to the above number. Also, for the display form of each of the individual progress status displaying sections **52,** various display forms can be adopted, for example by using a bar graph or a pie chart or the like to display the progress statuses. The respective display contents of each of the individual progress status displaying sections **52** are also not limited to those shown in **FIG. 11****,** but can appropriately be configured, for example by displaying the proportion of the elapsed time to the standard operating time (target operating time), or the like.

### (Control flow in the respective control device 16 of each one of the production lines)

**FIGS. 9** to **11** are flow charts showing a procedure for producing the wire harness.

As shown in **FIGS. 9** to **11****,** first, the displaying control section **161** of the respective control device **16** of each one of the production lines displays the wire laying out drawing **143** on the plurality of display devices **14** on the basis of the wire laying out image data **171** stored in the storage section **17** of the control device **16.** After that, in step S10, operators IDs are scanned with the two code readers **19,** respectively. The operators IDs each refer to a code allocated to each one of the operators to identify that one of the operators, and are each being displayed on, for example a name tag or the like as a bar code. The information on the scanned operators IDs are stored in the storage section **17** of the respective control device **16** of that one of the production lines. At this point of time, the displaying control section **161** of the control device **16** may be configured in such a manner as to display an indication of reading in the operators IDs on the plurality of display devices **14** of that one of the production lines. In this case, the displaying control section **161** displays the operation in progress indicator **148** on the display devices **14** with the indication of reading in the operators IDs, respectively, being displayed thereon. When the operators IDs are scanned, the displaying control section **161** of the control device **16** displays the two wire laying out position indicators **145** including thereon the two bar codes **146** of the electric wire **11** to be first laid out on the plurality of display devices **14.** The two wire laying out position indicators **145** are displayed adjacent to both the end portions, respectively, of that electric wire **11** to be laid out. The displaying control section **161** displays the operation in progress indicator **148** on the display devices **14** with the two wire laying out position indicators **145,** respectively, being displayed thereon.

After that, in step S**11**, the operators scan the first bar codes **146** (the bar codes **146** being included in the first two wire laying out position indicators **145)** displayed on the plurality of display devices **14.** After that, in step S**12**, the two-dimensional code of the production number of that electric wire **11** to be first laid out is scanned. Specifically, the electric wire identification code attached to the reel **121** is read in with the two code readers **19.** The displaying control section **161** of the control device **16** may be configured in such a manner that, at this point of time, if the production number of that electric wire **11** included in the information in the electric wire identification code is not matching the production number of that electric wire **11** in the operation recipe information **172,** then that displaying control section **161** displays a reel replacement indication on the plurality of display devices **14,** for example.

After that, in step S**13**, when the first bar codes **146** displayed on the plurality of display devices **14** are scanned again, in step S**14**, the electric wire cutting control section **162** of the control device **16** controls the electric wire feeding device **12** and the electric wire cutting machine **13,** and cuts the nth electric wire **11** to the electric wire length set in the operation recipe information **172.** In addition, in parallel with step S**14**, in steps S**15**a and S**15**b, the ring marks **181** and the mark tapes **182** are printed with the two printers **18** at both one end side and the other end side of that electric wire **11.** The operators use, as markers, the wire laying out image data **171** and the bar codes **146** displayed on the plurality of display devices **14,** and arrange that cut electric wire **11** while attaching the ring marks **181** and the mark tapes **182** to both the end portions of that electric wire **11.**

After that, in step S**16**, a continuity checking is performed. The displaying control section **161** of the control device **16** displays the operation in progress indicator **148** for the continuity checking. Further, the continuity checking section **164** of the control device **16** displays the continuity check indicator **146**b on the plurality of display devices **14** by means of that displaying control section **161** (see **FIG. 7****).** The operators bring the probes of the two continuity checking testers **20** into contact with the conductor of that electric wire **11** at both the end portions, respectively, of that electric wire **11.** The continuity checking section **164** of the control device **16** computes the electric conductivity of that electric wire **11** on the basis of the outputs of the two continuity checking testers **20,** and if the computed electric conductivity of that electric wire **11** falls within a predetermined normal value range, then an acceptance decision is made as a result of the continuity checking. The continuity checking section **164** of the control device **16** may be configured in such a manner that if a rejection decision is made as a result of the continuity checking, then that continuity checking section **164** displays alert information on the plurality of display devices **14** by means of the displaying control section **161** of the control device **16.** If that rejection decision is made in the continuity checking, then the flow returns to step S**16** to perform the continuity checking. Further, the continuity checking section **164** of the control device **16** may be configured in such a manner that if that rejection decision is repeatedly made a predetermined number of times in the continuity checking in step S**16,** then the flow returns to step S**13**, to redo the laying out of the first electric wire **11** to be laid out. In this case, that electric wire **11** having been rejected in the continuity checking is discarded.

After that acceptance decision has been made in the continuity checking in step S**16,** a scanning of the two-dimensional codes **182**a on the mark tapes **182** attached to both the end portions, respectively, of that electric wire **11** (steps S**17**a and S**17**b) and a scanning of the bar codes **146** for an area label displayed on the plurality of display devices **14** (steps S**18**a and S**18**b) are performed at each of both the end portions of that electric wire **11,** followed by a printing of the area label tapes **183** being performed by the two printers **18** (steps S**19**a and S**19**b). So, the operators attach those area label tapes **183** to predetermined places on that electric wire **11** and subsequently scan the two-dimensional codes **183**a on those area label tapes **183** (steps S**20**a and S**20**b). By performing the above steps, the wire laying out operation for the first electric wire **11** is completed.

After that, in step S**21**, a cutting of the electric wire **11** to be next laid out is performed, while in steps S**22**a and **22**b, a printing of the ring marks **181** and the mark tapes **182** of that electric wire **11** is performed. In addition, at this point of time, the bar codes **146** are displayed adjacent to both the end portions of that electric wire **11** to be laid out. The operators use, as markers, the wire laying out image data **171** and the bar codes **146** displayed on the plurality of display devices **14,** and arrange that cut electric wire **11** while attaching the ring marks **181** and the mark tapes **182** to both the end portions of that electric wire **11.** After that, in step S**23**, a continuity checking is performed. If a rejection decision is made as a result of the continuity checking, then the flow returns to step S**23** to perform the continuity checking.

If an acceptance decision is made as a result of the continuity checking in step S**23**, then, in step S**24**, the control device **16** looks up the operation recipe information **172** and makes a decision as to whether that electric wire **11** having been subjected to the continuity checking is the last electric wire **11** to be laid out. If a Yes decision is made in step S**24,** then the flow progresses to step S**29**.

If a No decision is made in step S**24**, then, in step S**25**, the control device **16** looks up the operation recipe information **172,** and makes a decision as to whether the next electric wire **11** to be laid out is the same in the area (the same in the area label) as that electric wire **11** currently being laid out, that is, that electric wire **11** having been subjected to the continuity checking in step S**23.** If a Yes decision is made in step S**25**, then the flow returns to steps S**21,** S**22**a, and S**22**b, to perform the wire laying out operation for the next electric wire **11.**

If a No decision is made in step S25, then the displaying control section **161** of the control device **16** displays the bar codes **146** for the area label adjacent to both the end portions, respectively, of that electric wire **11** on the plurality of display devices **14.** The operators perform a scanning of those bar codes **146** for the area label displayed on the plurality of display devices **14,** at each of both the end portions of that electric wire **11** (Steps S**26**a and S**26**b), followed by a printing of the area label tapes **183** being performed by the two printers **18** (steps S**27**a and S**27**b). So, the operators attach those area label tapes **183** to predetermined places on that electric wire **11** and subsequently scan the two-dimensional codes **183**a on those area label tapes **183** (steps S**28**a and S**28**b). After that, the flow returns to steps S**21**, S**22**a, and S**22**b, to perform the wire laying out operation for the next electric wire **11.**

After finishing the wire laying out of all the electric wires **11,** in step S**29**, the operators scan bar codes for a P/N label displayed on the plurality of display devices **14.** Note that, prior to step S**29**, the displaying control section **161** of the control device **16** displays the bar codes for the P/N label on the plurality of display devices **14.** When the operators have scanned the bar codes for the P/N label, the P/N labels are printed by the two printers **18** in step S**30**. Note that the P/N labels are a label configured to indicate a production number (a part number) of the wire harness, and to include a production number, a product name, a drawing number, and the like included in the operation recipe information **172** being printed on that label as character information and a two-dimensional code. Since the P/N labels are used to identify the entire wire harness, the P/N labels are attached to a trunk portion of the wire harness. After having attached the P/N labels to predetermined places on the wire harness, the operators scan the two-dimensional codes on the P/N labels in step S**31**.

After that, the displaying control section **161** of the control device **16** displays bar codes for start of a tape wrapping operation on the plurality of display devices **14.** The operators scan the bar codes for start of the tape wrapping operation displayed on the plurality of display devices **14** in step S**32**. At this point of time, the positions for the tape wrapping are displayed on the plurality of display devices **14.** The positions for the tape wrapping are indicated by a color or a frame or the like, for example. Further, the displaying control section **161** of the control device **16** displays bar codes for finish of the tape wrapping operation on the plurality of display devices **14.** After having performed the tape wrapping operation, the operators scan the bar codes for finish of the tape wrapping operation in step **S33.**

When the operators have scanned the bar codes for finish of the tape wrapping operation, an incorrect electric wire detection program (Incorrect wire detection program) is started in step S**34**. The incorrect electric wire detection program is a program, which is configured to check whether the operating time is excessively short or long in comparison to the preset standard operating time, and check an incorrect operating order or an operation skipping, on the basis of the operation history information (the progress status administration information **173).**

After that, the displaying control section **161** of the control device **16** displays bar codes for start of a protective material mounting operation on the plurality of display devices **14.** The operators scan the bar codes for start of the protective material mounting operation displayed on the plurality of display devices **14** in step S**35**. At this point of time, the positions for the protective material mounting are displayed on the plurality of display devices **14.** The positions for the protective material mounting are indicated by, for example, a color or a frame or the like. Further, the displaying control section **161** of the control device **16** displays bar codes for finish of the protective material mounting operation on the plurality of display devices **14.** After having performed the protective material mounting operation, the operators scan the bar codes for finish of the protective material mounting operation in step S**36.**

After that, the displaying control section **161** of the control device **16** displays bar codes for start of an inspection operation on the plurality of display devices **14.** The operators scan the bar codes for start of the inspection operation displayed on the plurality of display devices **14** in step S**37**. After having performed the predetermined inspection operation, the operators scan bar codes for finish of the inspection operation in step S**38**. By performing the above steps, the wire harness is produced, and the wire laying out step is completed.

The times at which the bar codes **146,** or the two-dimensional codes, or the like have been scanned in each of the above steps, are stored in the storage section **17** of the control device **16** as the progress status administration information **173,** by the time recording portion **165.** The progress status administrating section **211** of the administrating server **21** is configured to appropriately update the progress information on the progress status display screen **51** on the basis of the progress status administration information **173** having been stored in the storage section **17** of the control device **16.** For example, the progress status administrating section **211** of the administrating server **21** may be configured in such a manner as to update the progress information every time the bar codes **146** or the two-dimensional codes or the like have been scanned, or may be configured in such a manner as to update the progress information at appropriate time intervals.

Further, the operation history information may be configured in such a manner as to be created and stored on the basis of the progress status administration information **173** having been stored in the storage section **17** of the control device **16** or the storage section **22** of the administrating server **21.** The operation history information refers to a data log configured to include the histories of the operations and the times taken for the operations summarized therein. For example, as shown in **FIG. 12****,** the operation history information **174** is configured to include a Side for indicating a position of an end portion and denoting a connection destination area (e.g., a connection destination device or the like), an Item/Operation for denoting the electric wires **11** or the contents of the operations, a Date for denoting the times, an Additional Info for indicating details of the contents of the operations or the like, a length for denoting the electric wire lengths, the contents of the scans such as start / finish / check or the like, or a Scanned for denoting the results of the electric conductivity measurement in the continuity checking, a Time for denoting the operating times, and information such as More Info or the like for denoting other additional information. In **FIG. 12****,** a Part Number denotes the production number of the wire harness, a Start denotes the production start time of the wire harness, a Finish denotes the production finish time of the wire harness, Operators denote the operators IDs, and a Total denotes the time taken to produce the wire harness. Note that the information included in the operation history information **174** can be altered as appropriate.

### (Actions and advantageous effects of the embodiment)

As described above, in the wire harness producing device **10** according to the present embodiment, the operation recipe information **172** is configured to include the coordinate information indicating the two displaying positions for the wire laying out position indicators **145,** and the displaying control section **161** of the control device **16** is configured to display the wire laying out position indicators **145** in the two displaying positions respectively indicated by the coordinate information on that plurality of display devices **14.**

As a result, it is possible to set the displaying positions for the wire laying out position indicators **145** for each one of the electric wires **11** to be laid out, for example display the wire laying out position indicators **145** at the positions adjacent to the end portions respectively of that one of the electric wires **11** to be laid out. The operators can perform the wire laying out of the electric wires **11** by using the displaying positions for the wire laying out position indicators **145** as a guide, thereby being able to greatly improve the operation efficiency in performing the wire laying out operation and the like while being able to suppress the occurrence of an incorrect wire laying out. Since the wire harness designed to be used in a train vehicle such as a train or the like is constituted by using a large number of the electric wires, by altering the displaying positions for the wire laying out position indicators **145** for each of the electric wires **11** to be laid out so as to properly navigate the operators, it is possible to highly efficiently perform the wire laying out operation and the like, and it is therefore possible to efficiently produce the wire harness. Further, since the wire laying out position indicators **145** (in other words, the operation indications) are displayed in accordance with the wire laying out order set in the operation recipe information **172,** the operation order is standardized, thereby being able to ensure the improvement of the operation efficiency, regardless of the experience or skill of the operator.

## Claims

1. A wire harness producing device (10), which is configured to produce a wire harness by displaying a wire laying out drawing (143) including electric wire images (**11**a) of a plurality of laid out electric wires **(11)** in a full size in a length direction on a plurality of display devices, and for laying out said electric wires (11) along the wire laying out drawing, the device comprising
a control device (16) comprising:
a displaying control section (161) configured to look up operation recipe information (172) configured as a database capable of identifying wire laying out order numbers of the electric wires (11), and in turn display wire laying out position indicators (145) configured to indicate positions of the electric wires (11) to be laid out, on the plurality of display devices (14), in accordance with a wire laying out order of the electric wires (11), with the operation recipe information (172) including coordinate information for indicating displaying positions for the wire laying out position indicators (145), with the displaying control section (161) configured to display the wire laying out position indicators (145), in the displaying positions indicated by the coordinate information on the plurality of display devices (14),
wherein the displaying control section (161) is configured to, when switching the wire laying out position indicators (145), erase a current one of the wire laying out position indicators (145) while displaying a next one of the wire laying out position indicators (145) to display only the wire laying out position indicator for the electric wire (11) currently being laid out,
**characterized in that**
the displaying control section (161) is configured to display a guide indicator (147) being an arrow which is extending from the displaying position for the erased wire laying out position indicator **(145)** to the displaying position for the next wire laying out position indicator **(145)** for indicating to an operator a displaying position for the next one of the wire laying out position indicators (145).

2. The wire harness producing device according to claim 1, wherein the operation recipe information includes two pieces of the coordinate information of vicinities of respective two end portions of the electric wires to be laid out, with the displaying control section configured to display the wire laying out position indicators, in the displaying positions indicated by the two pieces of the coordinate information, respectively, on the plurality of display devices.

3. The wire harness producing device according to claim **1** or **2,** wherein the wire laying out position indicators include identification codes of the electric wires to be laid out, respectively.

4. The wire harness producing device according to claim **3,** further comprising:
a time recording section configured to store, in a storage section, times at which the identification codes respectively have been read.

5. The wire harness producing device according to any one of claims **1** to **3,**
wherein the plurality of display devices are each configured with a touch panel, and a time recording section is included to store, in a storage section, times at which the wire laying out position indicators respectively have been touched.

6. The wire harness producing device according to any one of claims **1** to 5, wherein the displaying control section is configured to display an operation in progress indicator on a predetermined region of the plurality of display devices with the wire laying out position indicators being displayed thereon, with the operation in progress indicator indicating that the wire laying out position indicators are displayed on that plurality of display devices.

7. The wire harness producing device according to any one of claims **1** to 6, wherein the wire laying out position indicators each include thereon an icon indicating an operation content.

8. The wire harness producing device according to claim 3 or 4, wherein during continuity check, a continuity check indicator (146b) is displayed in such a manner as to partially overlap with the identification codes of the electric wires, with locations of the wire laying out position indicators (145) being able to be identified by the operator, but with the identification codes of the electric wires being unable to be read by the operator.

## Patentansprüche

1. Vorrichtung (10) zur Herstellung eines Kabelbaums, die zur Herstellung eines Kabelbaums konfiguriert ist, indem sie eine Kabelverlegungszeichnung (143) mit elektrischen Kabelbildern (11a) einer Vielzahl von verlegten elektrischen Kabeln (11) in voller Größe in Längsrichtung auf einer Vielzahl von Anzeigevorrichtungen anzeigt und die elektrischen Kabel (11) entlang der Kabelverlegungszeichnung verlegt, wobei die Vorrichtung umfasst
eine Steuervorrichtung (16), die umfasst:
einen Anzeigesteuerungsabschnitt (161), der so konfiguriert ist, dass er Betriebsrezeptinformationen (172) nachschlägt, die als Datenbank konfiguriert sind, die in der Lage ist, die Verlegeauftragsnummern der elektrischen Kabel (11) zu identifizieren, und wiederum Kabelverlegepositionsanzeigen (145) anzeigt, die so konfiguriert sind, dass sie Positionen der zu verlegenden elektrischen Kabel (11) auf den mehreren Anzeigevorrichtungen (14) anzeigen, gemäß einer Verlegeanordnung der elektrischen Kabel (11), wobei die Betriebsrezeptinformationen (172) Koordinateninformationen zum Anzeigen von Anzeigepositionen für die Verlegepositionsanzeigen (145) umfassen, wobei der Anzeigesteuerungsabschnitt (161) so konfiguriert ist, dass er die Verlegepositionsanzeigen (145) an den durch die Koordinateninformationen angegebenen Anzeigepositionen auf den mehreren Anzeigevorrichtungen (14) anzeigt, wobei
der Anzeigesteuerungsabschnitt (161) so konfiguriert ist, dass er beim Umschalten der Kabelverlegepositionsanzeigen (145) eine aktuelle der Kabelverlegepositionsanzeigen (145) löscht, während er eine nächste der Kabelverlegepositionsanzeigen (145) anzeigt, um nur die Kabelverlegepositionsanzeige für das derzeit verlegte elektrische Kabel (11) anzuzeigen,
**dadurch gekennzeichnet, dass**
der Anzeigesteuerungsabschnitt (161) so konfiguriert ist, dass er eine Führungsanzeige (147) in Form eines Pfeils anzeigt, der sich von der Anzeigeposition für die gelöschte Drahtverlegepositionsanzeige (145) zur Anzeigeposition für die nächste Drahtverlegepositionsanzeige (145) erstreckt, um einem Bediener eine Anzeigeposition für die nächste der Drahtverlegepositionsanzeigen (145) anzuzeigen.

2. Die Vorrichtung zur Herstellung von Kabelbäumen gemäß Anspruch 1, wobei die Betriebsrezeptinformationen zwei Koordinateninformationen für die jeweiligen Umgebungen der beiden Endabschnitte der zu verlegenden elektrischen Kabel umfassen, wobei der Anzeigesteuerungsabschnitt so konfiguriert ist, dass er die Drahtverlegepositionsanzeigen an den durch die beiden Koordinateninformationen angegebenen Anzeigepositionen auf den mehreren Anzeigevorrichtungen anzeigt.

3. Vorrichtung zur Herstellung von Kabelbäumen gemäß Anspruch 1 oder 2, wobei die Drahtverlegepositionsanzeigen jeweils Identifikationscodes der zu verlegenden elektrischen Kabel umfassen.

4. Vorrichtung zur Herstellung von Kabelbäumen gemäß Anspruch 3, die ferner umfasst:
einen Zeitaufzeichnungsabschnitt, der so konfiguriert ist, dass er in einem Speicherabschnitt die Zeiten speichert, zu denen die Identifikationscodes jeweils gelesen wurden.

5. Vorrichtung zur Herstellung von Kabelbäumen gemäß einem der Ansprüche 1 bis 3, wobei die mehreren Anzeigevorrichtungen jeweils mit einem Touchpanel konfiguriert sind und ein Zeitaufzeichnungsabschnitt enthalten ist, um in einem Speicherabschnitt Zeiten zu speichern, zu denen die Kabelverlegepositionsanzeigen jeweils berührt wurden.

6. Vorrichtung zur Herstellung von Kabelbäumen gemäß einem der Ansprüche 1 bis 5, wobei der Anzeigesteuerungsabschnitt so konfiguriert ist, dass er einen Indikator für einen laufenden Vorgang in einem vorbestimmten Bereich der mehreren Anzeigevorrichtungen anzeigt, wobei die Drahtverlegepositionsindikatoren darauf angezeigt werden, wobei der Indikator für einen laufenden Vorgang anzeigt, dass die Drahtverlegepositionsindikatoren auf diesen mehreren Anzeigevorrichtungen angezeigt werden.

7. Vorrichtung zur Herstellung von Kabelbäumen gemäß einem der Ansprüche 1 bis 6, wobei die Kabelverlegepositionsanzeigen jeweils ein Symbol enthalten, das einen Vorgang anzeigt.

8. Vorrichtung zur Herstellung von Kabelbäumen gemäß Anspruch 3 oder 4, wobei während der Durchgangsprüfung eine Durchgangsprüfanzeige (146b) so angezeigt wird, dass sie sich teilweise mit den Identifikationscodes der elektrischen Kabel überlappt, wobei die Positionen der Drahtverlegepositionsanzeigen (145) vom Bediener identifiziert werden können, die Identifikationscodes der elektrischen Kabel jedoch vom Bediener nicht gelesen werden können.

## Revendications

1. Un dispositif (10) de fabrication d'un faisceau de câbles, qui est configuré pour fabriquer un faisceau de câbles en affichant un schéma (143) de disposition des câbles comprenant des images (11a) de câbles électriques d'une pluralité de câbles électriques agencés (11), en taille réelle, dans la direction de la longueur, sur une pluralité de dispositifs d'affichage, et pour disposer lesdits câbles électriques (11) le long du schéma de disposition des câbles, le dispositif comprenant
un dispositif de commande (16) comprenant :
une section (161) de commande d'affichage, configurée pour rechercher des informations (172) relatives au mode opératoire configurées sous la forme d'une base de données apte à identifier des numéros d'ordre de disposition des câbles électriques (11), et pour afficher à tour de rôle des indicateurs (145) de position de disposition des câbles configurés pour indiquer des positions des câbles électriques (11) à disposer, sur la pluralité de dispositifs d'affichage (14), conformément à un ordre de disposition des câbles électriques (11), les informations (172) relatives au mode opératoire comprenant des informations de coordonnées pour indiquer les positions d'affichage des indicateurs (145) de position de disposition des câbles, la section (161) de commande d'affichage étant configurée pour afficher les indicateurs (145) de position de disposition des câbles aux positions d'affichage indiquées par les informations de coordonnées sur la pluralité de dispositifs d'affichage (14), la section (161) de commande d'affichage étant configurée pour, lors de la commutation des indicateurs (145) de position de disposition des câbles, effacer un indicateur actuel (145) de position de disposition des câbles tout en affichant un indicateur suivant (145) de position de disposition des câbles afin d'afficher uniquement l'indicateur de position de disposition des câbles pour le câble électrique (11) en cours de disposition,
**caractérisé en ce que**
la section (161) de commande d'affichage est configurée pour afficher un indicateur de guidage (147) qui est une flèche s'étendant de la position d'affichage d'un indicateur effacé (145) de position de disposition des câbles à la position d'affichage d'un indicateur suivant (145) de position de disposition des câbles afin d'indiquer à un opérateur une position d'affichage pour un indicateur suivant (145) de position de disposition des câbles parmi les indicateurs (145) de position de disposition des câbles.

2. Le dispositif de production de faisceau de câbles selon la revendication 1, dans lequel les informations relatives au mode opératoire comprennent deux informations de coordonnées des voisinages de deux parties d'extrémité respectives des câbles électriques à disposer, la section de commande d'affichage étant configurée pour afficher les indicateurs de position de disposition des câbles, dans les positions d'affichage indiquées par les deux informations de coordonnées, respectivement, sur la pluralité de dispositifs d'affichage.

3. Le dispositif de production de faisceau de câbles selon la revendication 1 ou la revendication 2, dans lequel les indicateurs de position de disposition de câbles comprennent des codes d'identification des câbles électriques à disposer, respectivement.

4. Le dispositif de production de faisceau de câbles selon la revendication 3, comprenant en outre :
une section d'enregistrement de temps configurée pour stocker, dans une section de stockage, les moments auxquels les codes d'identification ont chacun été lus.

5. Le dispositif de production de faisceau de câbles selon l'une quelconque des revendications 1 à 3, dans lequel les dispositifs d'affichage de la pluralité de dispositifs d'affichage sont chacun configurés avec un panneau tactile, et une section d'enregistrement de temps est incluse pour stocker, dans une section de stockage, les moments auxquels les indicateurs de position de disposition des câbles ont été respectivement touchés.

6. Le dispositif de production de faisceau de câbles selon l'une quelconque des revendications 1 à 5, dans lequel la section de commande d'affichage est configurée pour afficher un indicateur d'opération en cours sur une zone prédéterminée de la pluralité de dispositifs d'affichage avec les indicateurs de position de disposition des câbles affichés sur elle, l'indicateur d'opération en cours indiquant que les indicateurs de position de disposition des câbles sont affichés sur cette pluralité de dispositifs d'affichage.

7. Le dispositif de production de faisceau de câbles selon l'une quelconque des revendications 1 à 6, dans lequel les indicateurs de position de disposition de câbles comprennent chacun une icône indiquant un contenu d'opération.

8. Le dispositif de production de faisceau de câbles selon la revendication 3 ou la revendication 4, dans lequel, pendant le contrôle de continuité, un indicateur (146b) de contrôle de continuité est affiché de manière à chevaucher partiellement les codes d'identification des câbles électriques, les emplacements des indicateurs (145) de position de disposition des câbles étant aptes à être identifiés par l'opérateur, mais les codes d'identification des câbles électriques ne pouvant pas être lus par l'opérateur**.**
